Europäisches Patentamt

**European Patent Office**

Office européen des brevets

(19)

(11) Publication number: **0 026 884**
**B1**

(12)

# EUROPEAN PATENT SPECIFICATION

(45) Date of publication of patent specification: **22.01.86**

(21) Application number: **80105843.9**

(22) Date of filing: **26.09.80**

(51) Int. Cl.⁴: **G 03 B 9/10,** G 03 B 41/00, G 03 B 9/58

(54) **Shutter mechanism.**

(30) Priority: **09.10.79 US 82484**
**09.10.79 US 82485**

(43) Date of publication of application:
**15.04.81 Bulletin 81/15**

(45) Publication of the grant of the patent:
**22.01.86 Bulletin 86/04**

(84) Designated Contracting States:
**DE FR GB IT**

(56) References cited:
**FR-A-2 140 073**
**GB-A-1 478 841**
**US-A-3 704 659**

(73) Proprietor: **EATON-OPTIMETRIX INC.**
**4001 North First Street**
**San Jose California 95134 (US)**

(72) Inventor: **Phillips, Edward H.**
**P.O.Box 1042**
**Middletown California 95461 (US)**
Inventor: **Wise, Lawrence A.**
**1479 Hollenbeck Avenue**
**Sunnyvale California 94087 (US)**

(74) Representative: **Liesegang, Roland, Dr.-Ing.**
**Sckellstrasse 1**
**D-8000 München 80 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to a shutter mechanism including a housing having a shutter aperture, a shutter rotatably mounted within the housing for opening and closing the shutter aperture, and a drive unit coupled to the shutter for unidirectionally rotating the shutter during each exposure period between an initial rest position and a final rest position with a variable velocity profile.

Various shutter mechanisms are employed in photometric printing systems of the type used, for example, in the semiconductor industry to photometrically print an image of a photomask or a reticle on a semiconductive wafer by exposing selected regions of a photosensitive film on the semiconductive wafer to exposure light passing through the photomask or the reticle. In order to photometrically print this image on the semiconductive wafer with high resolution, it is very important to uniformly illuminate the photomask or the reticle and, hence, the selected regions of the photosensitive film on the semiconductive wafer with the exposure light. The shutter mechanisms conventionally employed in such photometric printing systems control the exposure period, but typically do not open all portions of the shutter aperture for the same length of time. Thus, the photomask or the reticle and, hence, the selected regions of the photosensitive film on the semiconductive wafer are therefore typically not uniformly illuminated with the exposure light. In addition to this important drawback, the shutter mechanisms conventionally employed in such photometric printing systems are typically larger and slower than desired for many photometric printing applications.

In one known shutter mechanism an occulting disc opens and closes the shutter aperture at a constant velocity (US-Patent 3,704,659). In another known shutter mechanism the shutter may be programmed to stop during exposure, to rotate at a continuous angular velocity through the exposure position, or to rotate through the exposure position either more rapidly or less rapidly than through the non-exposure position (UK-Patent 1,478,841). However, in either case the user cannot select a velocity profile precisely suited to the performance requirements of the shutter mechanism.

It is an object of the invention to overcome the foregoing drawbacks of shutter mechanisms conventionally employed in photometric printing systems, and to provide an improved shutter mechanism capable of precisely accommodating varying performance requirements.

In accordance with the invention a shutter mechanism of the initially specified kind is characterized in that the opening movement of the shutter between the initial rest position and an intermediate rest position (open) is controlled with respect to shutter position by a first variable velocity profile, and that closing movement of the shutter between the intermediate and the final rest position is controlled with respect to shutter position by a second variable velocity profile matching the first variable velocity profile.

Preferably a shutter mechanism according to the invention has a cylindrical housing with a conically-shaped shutter cover coaxially disposed and fixedly mounted at one end thereof. A conically-shaped shutter provided with a pair of matching diametrically-opposite openings in the side thereof is coaxially and rotatably mounted within the housing directly adjacent to the shutter cover. As the shutter rotates, it alternately opens and closes a circular shutter aperture provided in the shutter cover in direct alignment with the rotational path of the openings in the shutter. A drive unit is coaxially supported by the housing and is coupled to the shutter for unidirectionally rotating the shutter during each exposure period with the same velocity profile for opening and closing the shutter aperture so that all portions of the shutter aperture are open for the same length of time during each exposure period. Due to both the coaxial construction of the shutter mechanism and the conical shape of the shutter and the shutter cover, the size of the shutter mechanism may be reduced, thereby also reducing the moment of inertia and increasing the speed of the shutter mechanism.

In addition to the foregoing, the shutter mechanism of the present invention preferably uses an improved control circuit that provides both position control and velocity control. In previous velocity control circuits, the controlling (or command) reference input signal was typically a fixed or minimally adjustable signal which offered little flexibility with respect to many control applications. Furthermore, when running in both velocity and position control modes, previous control circuits offered comprised performance in accommodating both modes of operation. The improved control circuit of the present invention circumvents both of the above-mentioned drawbacks. The use of a controllable reference generator allows the user to select a velocity profile precisely suited to the performance requirements of the shutter mechanism. A feedback control loop, the topology of which may be altered under external control, delivers precise, consistant performance, whether operating in a position or a velocity control mode. When this feedback control loop and the controllable reference generator are combined and operated under the direction of a common controller, such as a computer, a high-performance control circuit is obtained with a minimized components count.

Figure 1 is a sectional view of a portion of a photometric printing system incorporating a rotary shutter mechanism according to the preferred embodiment of this invention.

Figures 2A and 2B are bottom plan and sectional side views, respectively, of the shutter cover of the rotary shutter mechanism of Figure 1.

Figures 3A and 3B are bottom plan and sectional side views, respectively, of the shutter of the rotary shutter mechanism of Figure 1.

Figure 4 is a waveform diagram illustrating the velocity profile of the shutter of Figures 3A and 3B for one complete cycle of shutter operation.

Figure 5 is a detailed graph of a portion of the velocity profile of Figure 4.

Figure 6 is a block diagram of the drive unit, including a drive motor and an improved control circuit according to the preferred embodiment of this invention, for driving the rotary shutter mechanism of Figure 1.

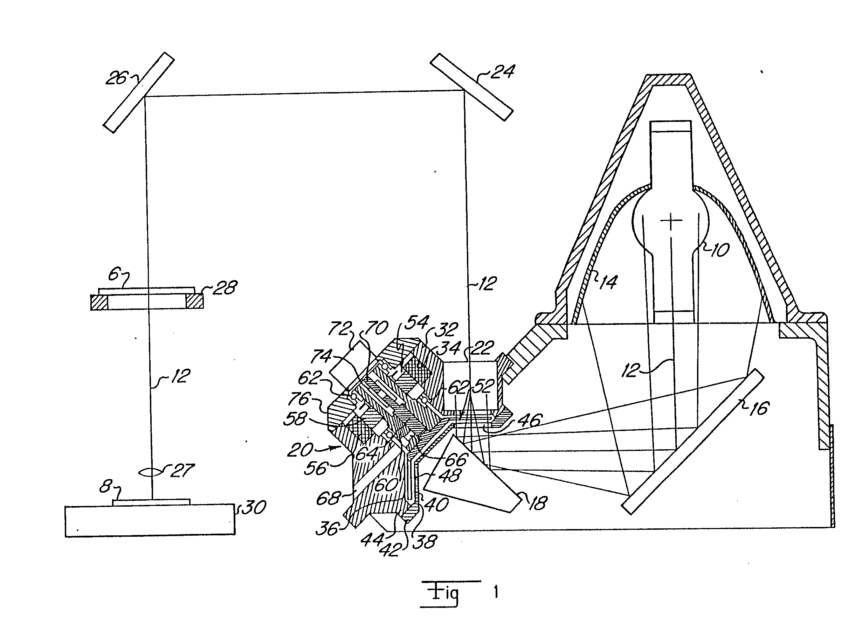

Referring to Figure 1, there is shown a portion of a photometric printing system for photometrically printing an image of a photomask or a reticle 6 on a semiconductive wafer 8 by selectively exposing a photosensitive film on the semiconductive wafer to exposure light passing through the photomask or the reticle as shown and described, for example, in EP—A—80 101 307.9. The exposure light is emitted by a mercury arc lamp 10 fixedly mounted along a downwardly-extending portion of an optical path 12 of the photometric printing system. An elliptically-shaped reflector 14 surrounds mercury arc lamp 10 and is fixedly coaxially mounted therewith for projecting a beam of the exposure light emitted by the mercury arc lamp along the downwardly-extending portion of optical path 12 to a band reflecting plane mirror 16. This mirror is fixedly mounted in optical path 12 at an angle of forty-five degrees with respect to the downwardly-extending portion thereof so as to deflect the beam of exposure light along a laterally-extending portion of the optical path to a plane mirror 18.

Plane mirror 18 is fixedly mounted in optical path 12 at an angle of forty-five degrees with respect to the laterally-extending portion thereof so as to deflect the beam of exposure light along an upwardly-extending portion of the optical path to a rotary shutter mechanism 20 and, when the shutter mechanism is opened, thence to a light integrator 22 fixedly mounted in the upwardly-extending portion of the optical path. Light integrator 22 is employed for providing the beam of exposure light passing therethrough with a uniform intensity distribution in the plane of the photomask or reticle 6 and is operable for doing so provided all portions of the input surface of the light integrator are exposed to the beam of exposure light for the same length of time. The photomask or reticle 6 is supported in optical path 12 at a location between the light integrator 22 and the semiconductive wafer 8 so that, when the rotary shutter mechanism 20 is opened, an image of the photomask or reticle may be photometrically printed on the semiconductive wafer by exposure of selected regions of the photosensitive film on the semiconductive wafer to the exposure light passing through the photomask or the reticle. Plane reflecting mirrors 24 and 26, lens 27, and other optics, as shown and described, for example, in EP—A—801 101 307.9, may be employed for projecting the beam of exposure light from light integrator 22 along optical path 12 to the photomask or reticle 6 and, thence, to the semiconductive wafer 8. In addition, the photomask or reticle 6 and the semiconductive wafer 8 may be supported on relatively movable stages 28 and 30, as further shown, for example, in EP—A—80 101 307.9, to facilitate alignment of the semiconductive wafer and the photomask or reticle before exposing the photosensitive film on the semiconductive wafer to the exposure light.

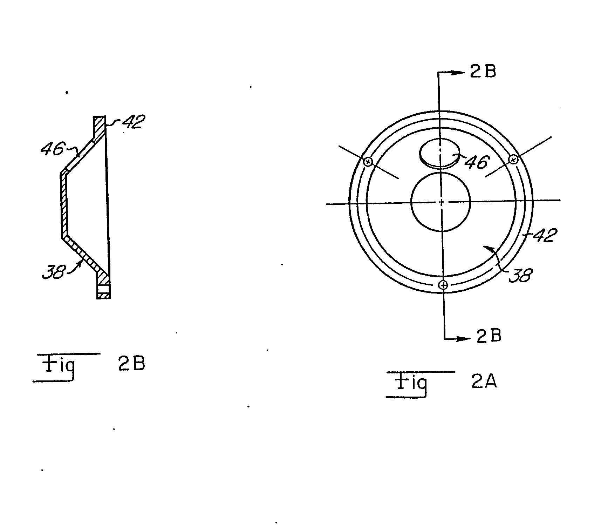

In accordance with the illustrated preferred embodiment of this invention, rotary shutter mechanism 20 has a cylindrical housing 32 with a cylindrical bore 34 having a conically-shaped end portion 36 of outwardly-increasing diameter. Referring now to Figures 1, 2A and 2B, a correspondingly conically-shaped shutter cover 38 of outwardly-increasing diameter is coaxially disposed in spaced relationship to the conically-shaped end portion 36 of housing 32 so as to provide a conically-shaped clearance space 40. The conically-shaped shutter cover 38 is fixedly held in place by securing an annular flange 42 thereof to a mating annular shoulder 44 of the conically-shaped end portion 36 of housing 32 with screws or the like. A circular shutter aperture 46 of sufficient size to permit passage of the beam of exposure light therethrough is formed in the side of the conically-shaped shutter cover 38 and in the adjacent portion of the housing 32. Rotary shutter mechanism 20 is fixedly mounted adjacent to the optical path 12 so that the shutter aperture 46 is disposed in direct alignment with the upwardly-extending portion of the optical path for receiving the beam of exposure light reflected therealong by plane mirror 18.

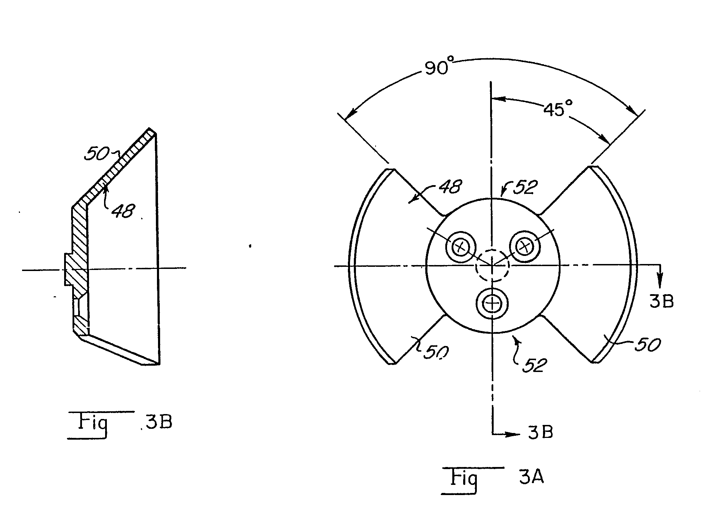

Referring now to Figures 1, 3A and 3B, there is coaxially and rotatably mounted within the conically-shaped clearance space 40 a correspondingly conically-shaped shutter 48 having a pair of matching diametrically-opposite side portios 50 each disposed for fully closing the shutter aperture 46 as the shutter rotates and an orthogonally-oriented pair of matching diametrically-opposite side openings 52, each disposed for fully opening the shutter aperture as the shutter rotates. Before the conically-shaped shutter cover 38 is actually secured in place, a cylindrically-shaped drive motor 54 (such as an Inland T-1342 DC torque motor manufactured and sold by the Inland Motor Division of the Kollmorgen Corporation) having a field magnet 56 and a rotor 58 is coaxially secured in place within the bore 34 of housing 32. A cylindrically-shaped hub 60 is inserted through an axial cylindrical bore of the rotor 58, affixed to the rotor, and coaxially supported within the bore 34 of housing 32 by bearings 62 for rotation with the rotor. The conically-shaped shutter 48 is fixedly secured to the hub 60 with screws or the like so as to rotate with the hub and within the conically-shaped clearance space 40. At this point the conically-shaped shutter cover 38 may be fixedly secured in place as described above.

A first shaft 64 is inserted within an axial cylindrical bore of hub 60 and affixed to the hub for rotation therewith by a set screw 66 that may be screwed into place through a clearance opening 68 provided for that purpose in housing 32. The first shaft 64 is coupled to a second shaft 70 of a potentiometer 72 by a bellows coupling 74 for accommodating any axial misalignment of the two shafts and for imparting rotation of the first shaft (and, hence, of the shutter 48) to the second shaft so that the potentiometer provides an output voltage proportional to the rotational position of the shutter. Potentiometer 72 is secured to a motor cover 76 which is coaxially secured in place at the non-conical end of housing 32 to seal off the cylindrical bore 34 of the housing and prevent dust or other foreign matter from impairing the operation of the drive motor 54.

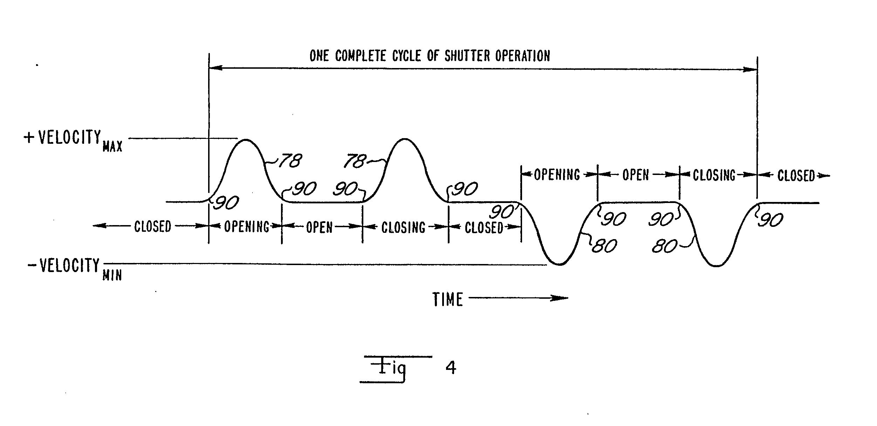

The potentiometer 72 is part of a control circuit, hereinafter described, electrically coupled to the drive motor 54 for controlling the shutter 48. This control circuit drives the drive motor 54 to unidirectionally rotate shutter 48 in one sense (for example, clockwise) with the same velocity profile 78 for both opening and closing the shutter aperture 46 during a first exposure period and to unidirectionally rotate the shutter in the opposite sense (for example, counter-clockwise) with the same velocity profile 80 for both opening and closing the shutter aperture during a second exposure period, as indicated in Figure 4 for one complete cycle of shutter operation. Thus, all portions of the shutter aperture 46 are open for the same length of time during each exposure period. This results in all portions of the input surface of the light integrator 22 being exposed to the beam of exposure light through the shutter aperture 46 of rotary shutter mechanism 20 for the same length of time during each exposure period and, hence, in substantially uniform illumination of the photomask or reticle 6 and of the selected regions of the photosensitive film on the semiconductive wafer 8 with exposure light, as required to photometrically print an image of the photomask or the reticle on the semiconductive wafer with high resolution.

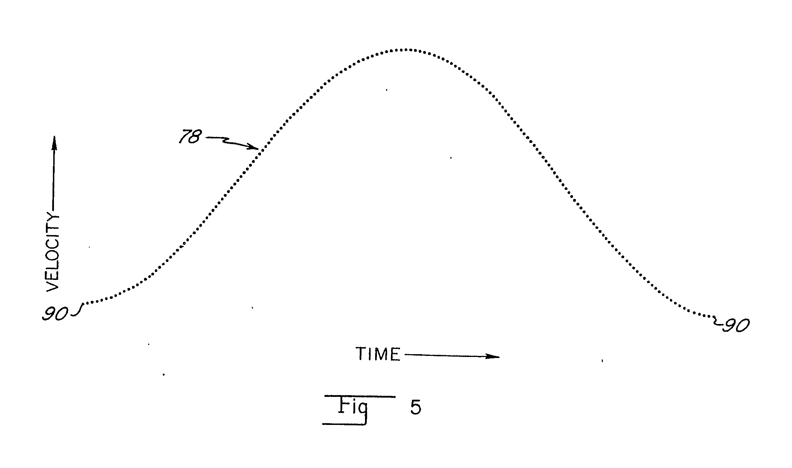

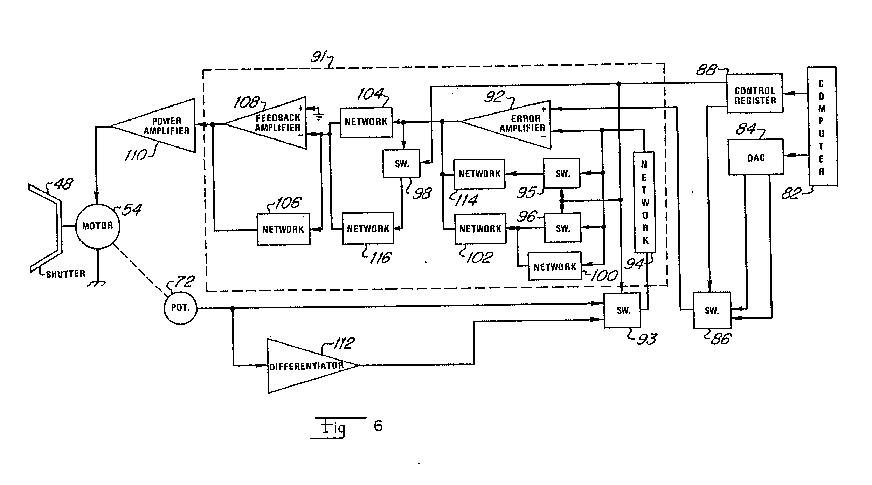

Since, as shown in Figure 4, the velocity profile 78 or 80 for rotating the shutter 48 to open the shutter aperture 46 is the same as the velocity profile 78 or 80 for rotating the shutter to close the shutter aperture during each exposure period, except that the velocity profile 78 for the first exposure period and the velocity profile 80 for the second exposure period are of opposite polarity, a detailed graph of only the velocity profile 78 for rotating the shutter to open the shutter aperture is shown in Figure 5. Each point on this graph represents a velocity datum stored, for example, in a computer 82 of the control circuit (see Figure 6) and supplied by the computer at the designated time intervals to generate a precise velocity profile with an optimized contour for controlling the position of the shutter 48 as well as an optimized contour for controlling the velocity of the shutter.

Referring now particularly to Figures 1, 5 and 6, each velocity datum stored in computer 82 is supplied as an eight-bit byte to a ditigal-to-analog converter 84 at the designated time interval (for example, one byte every five hundred microseconds). The digital-to-analog converter 84 converts each such byte to an analog velocity reference voltage and applies that analog velocity reference voltage along with a corresponding analog velocity reference voltage of opposite polarity to a single-pole double-throw switch 86. Computer 82 also supplies a two-bot control byte to a control register 88 at each transition 90 (see Figure 4) between position and velocity control to configure a feedback control loop 91 of the control circuit as required for the following period of position or velocity control and as further explained in detail below.

Assuming the shutter 48 is initially closed, as at the beginning of the first exposure period of each complete cycle of shutter operation, control register 88 sets switch 86 to apply the noninverted analog velocity reference voltage to the positive input of an error amplifier 92 and sets a single-pole double-throw switch 93 to apply an analog velocity feedback voltage signal from a differentiator 112 through a resistive-capacitive lead network 94 to the negative input of the error amplifier. Concomitantly, control register 88 opens single-pole single-throw switches 95, 96 and 98 to configure feedback control loop 91 of the control circuit for velocity feedback. When so configured a capacitive network 100 and resistive networks 102, 104, and 106 are operatively included in the feedback control loop 91. This arrangement of networks provides the feedback control loop 91 with an optimum gain-frequency contour for velocity control. The feedback control loop 91 includes a feedback amplifier 108 having its negative terminal connected to the junction of resistive networks 104 and 106 and having its positive terminal connected to ground. This feedback amplifier 108 provides a stage of amplification of the error signal from error amplifier 92. A power amplifier 110 is coupled to the output of feedback amplifier 108 to further amplify the error signal and to supply the power required to drive the drive motor 54 so as to rotate the shutter 48 in accordance with the velocity profile of Figure 5.

As indicated above, the potentiometer 72 is directly coupled to both the shutter 48 and the drive motor 54 so that the output voltage of the potentiometer is directly proportional to the rotational position of the shutter 48. The output voltage of the potentiometer 72 is differentiated by the differentiator 112 to yield the required analog velocity feedback voltage signal applied to switch 93 so as to close the feedback control loop 91 as confiigured for velocity control.

At the end of each period of velocity control, the shutter 48 is stationary and the feedback control loop 91 is switched to a position control configuration so as to insure that the next period of velocity control is started at the correct point. The computer 82 therefore supplies the digital-to-analog converter 84 with an eight-bit byte containing desired position information and supplies the control register 88 with a two-bit byte for switching the feedback control loop 91 to the position control configuration at the end of the above-described velocity control period. This causes the control register 88 to close switches 95, 96 and 98, to set the switch 86 for applying an analog position reference signal from the digital-to-analog converter 84 to the positive input of the error amplifier 92, and to set the switch 93 for directly applying the output voltage of the potentiometer 72 through the resistive-capacitive lead network 94 to the negative input of the error amplifer. With switches 95 and 96 closed, resistive network 102 and another resistive network 114 are operatively connected in parallel in the portion of feedback control loop 91 associated with the error amplifier 92. This yields a resistive feedback characteristic for the error amplifier 92. With switch 98 closed, a resistive-capacitive network 116 is operatively connected in parallel with resistive network 104 in the portion of the feedback control loop 91 associated with the feedback amplifier 108 to further increase the stability of the feedback loop as configured for position control.

## Claims

1. A shutter mechanism (20) including a housing (32) having a shutter aperture (46); a shutter (48) rotatably mounted within the housing for opening and closing the shutter aperture; and a drive unit (54, 110) coupled to the shutter for unidirectionally rotating the shutter during each exposure period between an initial rest position and a final rest position with a variable velocity profile, characterized in that the opening movement of the shutter between the initial rest position and an intermediate rest position (open) is controlled with respect to shutter position by a first variable velocity profile (78); and that closing movement of the shutter between the intermediate rest position and the final rest position is controlled with respect to shutter position by a second variable velocity profile (78) matching the first variable velocity profile.

2. A shutter mechanism as claimed in claim 1, characterized in that the drive unit (54, 110) includes a drive motor (54) coupled to the shutter (48) for rotating the shutter, the drive motor being mounted within the housing (32) coaxially with the shutter.

3. A shutter mechanism as claimed in claim 1 or 2, characterized by position feedback means (72) for indicating the position of the shutter (48).

4. A shutter mechanism as claimed in claim 3, characterized in that the position feedback means (72) includes a control element (70) coupled to the shutter (48) for rotation therewith.

5. A shutter mechanism as claimed in claim 3 or 4, characterized in that the drive unit (54, 110) includes velocity control means (112), coupled to the drive motor (54) and responsive to the position feedback means (72), for controlling each variable velocity profile (78) of the shutter.

6. A shutter mechanism as claimed in any of the preceding claims, characterized in that the housing (32) has a conically-shaped clearance space (40) communicating with the shutter aperture (46); and the shutter comprises a conically-shaped shutter (48) rotatably mounted within the conically-shaped clearance space of the housing.

7. A shutter mechanism as claimed in claim 6, characterized in that the shutter aperture (46) extends through a portion of the conically-shaped clearance space (40).

8. A shutter mechanism as claimed in any of the preceding claims, characterized in that the shutter (48) includes a pair of matching diametrically-opposite closure portions (50) each operable for fully closing the shutter aperture (46); and a pair of matching diametrically-opposite openings (52) orthogonally disposed relative to the closure portions and each operable for fully opening the shutter aperture.

9. A shutter mechanism as claimed in any of the preceding claims, characterized in that a servo-control circuit is provided for controlling both velocity and position of the shutter (48); the servo-control circuit includes a reference source (82, 84, 86), a feedback source (72, 93, 112), and a feedback control loop (91) coupled to the drive unit (54, 110) and to the reference and feedback sources; the reference source (82, 84, 86) is a reference source of velocity and position reference information indicative of the desired velocity and position of the shutter (48); the feedback source (72, 93, 112) is a feedback source of velocity and position feedback information indicative of the actual velocity and position of the shutter (48); the feedback control loop has a topology configurable for velocity control of the drive unit (54, 110) to control the velocity of the shutter (48) in accordance with velocity reference and feedback information from the reference and feedbak sources and differently configurable for position control of the drive unit (54, 110) to control the position of the shutter (48) in accordance with position reference and feedback information from the reference and feedback sources; and control means (82, 88) is coupled to the feedback control loop to configure the topology of the feedback control loop for velocity control of the drive unit (54, 110) in response to a command signal and to differently configure the topology of the feedback control loop for position control of the drive unit (54, 110) in response to another command signal.

10. A shutter mechanism as claimed in claim 9, characterized in that the feedback control loop (91) includes amplifying means (92, 108), coupled to the drive unit (54, 110) and to the reference and feedback sources (82—86 and 72, 93, 112), for supplying the drive unit with an error signal related to the difference between the velocity reference and feedback information when the topology of the feedback control loop is configured for velocity control of the drive unit and related to the difference between the position reference and feedack information when the topology of the feedback control loop is configured for position control of the drive unit; network means (94—106, 114, 116) is coupled in circuit with the amplifying means to determine the gain-frequency contour of the feedback control loop; and the network means includes switching means (95—98) for modifying the gain-frequency contour of the feedback control loop in response to one of the aforementioned command signals.

11. A shutter mechanism as claimed in claim 10, characterized in that the amplifying means includes a first amplifier (92) having first and second inputs coupled to the reference and feedback sources, respectively, and a second amplifier (108) having an input connected in series with an output of the first amplifier and having an output coupled to the drive unit; the network means includes first network means (100, 102, 114) for forming a feedback path from one of the first and second inputs to the output of the first amplifier, and second network means (104, 116) for coupling the output of the first amplifier to the aforementioned input of the second amplifier; and the switching means includes first and second switching means (95—96, 98) included in the first and second network means, respectively.

12. A shutter mechanism as claimed in claim 11, characterized in that the first network means comprises a first pair of networks (102, 114) coupled in parallel from said one of the first and second inputs to the output of the first amplifier (92); the second network means comprises a second pair of networks (104, 116) coupled in parallel from the output of the first amplifier (92) to the aforementioned input of the second amplifier (108); the first switching means comprises a switch (95), connected in series with one (114) of the first pair of networks from said one of the first and second inputs to the output of the first amplifier (92), for being opened or closed in response to said one of the command signals; and the second switching means comprises a switch (98), connected in series with one (116) or the second pair of networks from the output of the first amplifier (92) to the aforementioned input of the second amplifier (108), for being opened or closed in response to said one of the command signals.

13. A shutter mechanism as claimed in claim 12, characterized in that the first network means further comprises an additional network (100) connected in series with the other (102) of the first pair of networks from said one of the first and second inputs to the output of the first amplifier (92); and the first switching means further comprises an additional switch (96), connected in parallel with the additional network (100), for being opened or closed in response to said one of the command signals.

14. A shutter mechanism as claimed in any of the preceding claims 9 to 13, characterized in that the reference source (82, 84, 86) includes processing means (82) for storing and selectively providing the velocity and position reference information in a first form compatible with the processing means; conversion means (84), coupled to the processing means (82) and to the feedback control loop (91), for converting the velocity and position reference information from the processing means to a second form compatible with the feedback control loop; and means (86) for coupling the conversion means (84) to the feedback control loop (91) to supply the converted velocity and position reference information from the conversion means to the feedback control loop.

15. A shutter mechanism as claimed in claim 14, characterized in that the processing means comprises a digital computer (82); and the conversion means comprises a digital-to-analog converter (84) for converting the digital velocity and position reference information from the digital computer to analog velocity and position reference information for the feedback control loop.

16. A shutter mechanism as claimed in any of preceding claims 9 to 15, characterized in that the feedback source includes position feedback means (72) for monitoring the position of the shutter (48); velocity feedback means (112) for monitoring the velocity of the shutter (48); and means (93) for coupling the position and velocity feedback means (72, 112) to the feedback control loop (91) to supply the position and velocity feedback information from the position and velocity feedback means to the feedback control loop.

17. A shutter mechanism as claimed in claim 16, characterized in that the position feedback means includes a potentiometer (72) for producing a position feedback signal indicative of the actual position of the shutter (48); and the velocity feedback means includes a differentiator (112), coupled to the potentiometer (72), for producing a velocity feedback signal indicative of the actual velocity of the shutter (48).

18. A shutter mechanism as claimed in any of the preceding claims 14 to 17, characterized in that the control means includes processing means (82) for selectively providing the command signals; and register means (88), coupled to the processing means (82) and to the feedback control loop (91), for receiving the command signals from the processing means to configure the topology of the feedback control loop for velocity control of the drive unit (54, 110) in response to the first-mentioned command signal and to differently configure the topology of the feedback control loop for position control of the drive unit in response to the second-mentioned command signal.

19. A shutter mechanism as claimed in claim 18, characterized in that the register means (88) is also coupled to the reference and feedback sources (82—86 and 72, 93, 112) for selectively controlling the application of reference and feedback information from those sources to the feedback control loop (91).

**Revendications**

1. Un mécanisme d'obturateur (20) qui comporte un boîtier (32) ayant une ouverture d'obturateur (46); un obturateur (48) monté à rotation dans le boîtier pour ouvrir et fermer l'ouverture d'obturateur et un dispositif d'entraînement (54, 110) accouplé à l'obturateur de façon à faire tourner l'obturateur dans un seul sens au cours de chaque exposition entre une position de repos initiale et une position de repos finale suivant un profil de vitesse variable, caractérisé en ce que le mouvement d'ouverture de l'obturateur entre la position de repos initiale et une position de repos intermédiaire (ouverte) est commandé par rapport à la position de l'obturateur par un premier profil de vitesse variable (78); et en ce que le mouvement de fermeture de l'obturateur entre la position de repos intermédiaire et la position de repos finale est commandé par rapport à la position de l'obturateur par un second profil de vitesse variable (78) semblable au premier profil de vitesse variable.

2. Un mécanisme d'obturateur tel que revendiqué dans la revendication 1, caractérisé en ce que le dispositif d'entraînement (54, 110) comporte un moteur d'entraînement (54) accouplé à l'obturateur (48) pour faire tourner l'obturateur, le moteur d'entraînement étant monté dans le boîtier (32) coaxialement avec l'obturateur.

3. Un mécanisme d'obturateur tel que revendiqué dans la revendication 1 ou 2, caractérisé par des moyens (72) de réaction de position pour indiquer la position de l'obturateur (48).

4. Un mécanisme d'obturateur tel que revendiqué dans la revendication 3, caractérisé en ce que les moyens (72) de réaction de position comprennent un élément de commande (70) accouplé à l'obturateur (48) pour tourner avec lui.

5. Un mécanisme d'obturateur tel que revendiqué dans la revendication 3 ou 4, caractérisé en ce que le dispositif d'entraînement (54, 110) comprend des moyens (112) de commande de vitesse connectés au moteur d'entraînement (54) et fonctionnant en réponse aux moyens (72) de réaction de position pour commander chaque profil de vitesse variable (78) de l'obturateur.

6. Un mécanisme d'obturateur tel que revendiqué dans l'une quelconque des revendications précédentes, caractérisé en ce que le boîtier (32) comporte un espace libre (40) de forme conique qui communique avec l'ouverture d'obturateur (46); et l'obturateur est un obturateur (48) de forme conique monté à rotation à l'intérieur de l'espace libre de forme conique du boîtier.

7. Un mécanisme d'obturateur tel que revendiqué dans la revendication 6, caractérisé en ce que l'ouverture d'obturateur (46) s'étend à travers une partie de l'espace libre (40) de forme conique.

8. Un mécanisme d'obturateur tel que revendiqué dans l'une quelconque des revendications précédentes, caractérisé en ce que l'obturateur (48) comprend une paire de parties de fermeture semblables (50) diamétralement opposées, chacune susceptible d'obturer complètement l'ouverture d'obturateur (46); et une paire d'ouvertures semblables (52) diamétralement opposées disposées orthogonalement par rapport aux parties de fermeture et chacune susceptible d'ouvrir complètement l'ouverture d'obturateur.

9. Un mécanisme d'obturateur tel que revendiqué dans l'une quelconque des revendications précédentes, caractérisé en ce qu'un circuit de servocommande est utilisé pour commander à la fois la vitesse et la position de l'obturateur (48); le circuit de servocommande comprend une source (82, 84, 86) de signaux de référence, une source (72, 93, 112) de signaux de réaction et une boucle (91) de commande à réaction connectée au dispositif d'entraînement (54, 110) et aux sources de signaux de référence et de signaux de réaction; la source (82, 84, 86) de signaux de référence est une source de signaux de référence constitués par des informations de référence de vitesse et de position indicatives de la vitesse et de la position désirées de l'obturateur (48); la source (72, 93, 112) de signaux de réaction est une source de signaux de réaction constitués par des informations de position et de vitesse indicatives de la vitesse et de la position effectives de l'obturateur (48); la boucle de commande à réaction a une topologie susceptible d'être mise sous une configuration appropriée pour la commande de vitesse du dispositif d'entraînement (54, 110) afin de commander la vitesse de l'obturateur (48) conformément aux informations de référence et de réaction de vitesse fournies par les sources de signaux de référence et de signaux de réaction et susceptible d'être mise sous une configuration différente appropriée pour la commande de position du dispositif d'entraînement (54, 110) afin de commander la position de l'obturateur (48) conformément aux informations de référence et de réaction de position fournies par les sources de signaux de réaction et de signaux de référence; et des moyens de commande (82, 88) sont connectés à la boucle de commande à réaction pour mettre la topologie de la boucle de commande à réaction sous une configuration appropriée par la commande de vitesse du dispositif d'entraînement (54, 110) en réponse à un signal d'instruction et pour mettre la topologie de la boucle de commande à réaction sous une configuration différente pour la commande de position du dispositif d'entraînement (54, 110) en réponse à un autre signal d'instruction.

10. Un mécanisme d'obturateur tel que revendiqué dans la revendication 9, caractérisé en ce que la boucle (91) de commande à réaction comprend des moyens amplificateurs (92, 108) connectés au dispositif d'entraînement (54, 110) et aux sources (82—86 et 78, 93, 112) de signaux de référence et de réaction pour appliquer au dispositif d'entraînement un signal d'erreur fonction de la différence entre les informations de référence et de réaction de vitesse lorsque la topologie de la boucle de commande à réaction a été mise sous une configuration appropriée pour la commande de vitesse du dispositif d'entraînement et fonction de la différence entre les informations de référence et de réaction de position lorsque la topologie de la boucle de commande à réaction a été mise sous une configuration appropriée pour la commande de position du dispositif d'entraînement; des moyens (94—106, 114, 116) formant des réseaux sont connectés en circuit avec les moyens amplificateurs pour déterminer le contour gain-fréquence de la boucle de commande à réaction, et les moyens formant des réseaux comprennent des moyens de commutation (95—98) pour modifier le contour gain-fréquence de la boucle de commande à réaction en réponse à l'un des signaux d'instruction précités.

11. Un mécanisme d'obturateur tel que revendiqué dans la revendication 10, caractérisé en ce que les moyens amplificateurs comprennent un premier amplificateur (92) ayant des première et seconde entrées connectées respectivement à la source de signaux de référence et à la source de signaux de réaction et un second amplificateur (108) ayant une entrée connectée en série avec une sortie du premier amplificateur et ayant une sortie connectée au dispositif d'entraînement; les moyens formant des réseaux comprennent des premiers moyens (100, 102, 114) formant des réseaux pour former un trajet de réaction entre l'une des première et seconde entrées du premier amplificateur et sa sortie et des seconds moyens (104, 116) formant des réseaux pour coupler la sortie du premier amplificateur à l'entrée précitée du second amplificateur; et les moyens de commutation comprennent des premiers et seconds moyens de commutation (95—96, 98) inclus respectivement dans les premiers et dans les seconds moyens formant des réseaux.

12. Un mécanisme d'obturateur tel que revendiqué dans la revendication 11, caractérisé en ce que les premiers moyens formant des réseaux comprennent une paire de réseaux (102, 114) montés en parallèle entre ladite entrée desdites première et seconde entrées et la sortie du premier amplificateur (92); les seconds moyens formant des réseaux comprennent une seconde paire de réseaux (104, 116) montés en parallèle entre la sortie du premier amplificateur (92) et l'entrée précitée du second amplificateur (108); les premiers moyens de commutation comprennent un interrupteur (95) connecté en série avec un premier (114) des réseaux de la première paire de réseaux montés entre ladite entrée desdites première et seconde entrées et la sortie du premier amplificateur (92) de manière à être ouvert ou fermé en réponse audit premier signal d'instruction; et les seconds moyens de commutation comprennent un interrupteur (98) connecté en série avec un premier (116) des réseaux de la seconde paire de réseaux montés entre la sortie du premier amplificateur (92) et l'entrée précitée du second amplificateur (108) de manière à être ouvert ou fermé en réponse audit premier signal d'instruction.

13. Un mécanisme d'obturateur tel que revendiqué dans la revendication 12, caractérisé en ce que les premiers moyens formant des réseaux comprennent, en outre, un réseau supplémentaire (100) connecté en série avec l'autre réseau (102) de la première paire de réseaux montés entre ladite entrée desdites première et seconde entrées et la sortie du premier amplificateur (92); et les premiers moyens de commutation comprennent, en outre, un interrupteur supplémentaire (96) connecté en parallèle avec le réseau supplémentaire (100) de manière à être ouvert ou fermé en réponse audit premier signal d'instruction.

14. Un mécanisme d'obturateur tel que revendiqué dans l'une quelconque des revendications précédentes 9 à 13, caractérisé en ce que la source (82, 84, 86) de signaux de référence comprend des moyens de traitement (82) pour mettre en mémoire et fournir sélectivement les informations de référence de vitesse et de position sous une première forme compatible avec les moyens de traitement; des moyens de conversion (84) connectées aux moyens de traitement (82) et à la boucle (91) de commande à réaction pour convertir les informations de référence de vitesse et de position fournies par les moyens de traitement sous une seconde forme compatible avec la boucle de commande à réaction; et des moyens (86) pour coupler les moyens de conversion (84) à la boucle (91) de commande à réaction afin de fournir les informations de référence de vitesse et de position converties à la boucle de commande à réaction.

15. Un mécanisme d'obturateur tel que revendiqué dans la revendication 14, caractérisé en ce que les moyens de traitement sont constitués par un ordinateur numérique (82); et les moyens de conversion sont constitués par un convertisseur (84) de numérique en analogique servant à convertir les informations de référence de vitesse et de position numérique fournies par l'ordinateur numérique en informations de référence de vitesse et de position analogiques pour la boucle de commande à réaction.

16. Un mécanisme d'obturateur tel que revendiqué dans l'une quelconque des revendications précédentes 9 à 15, caractérisé en ce que la source de signaux de réaction comprend des moyens (72) de réaction de position pour contrôler la position de l'obturateur (48); des moyens (112) de réaction de vitesse pour contrôler la vitesse de l'obturateur (48); et des moyens (93) pour coupler les moyens (72, 112) de réaction de position et de vitesse à la boucle (91) de commande à réaction afin de fournir les informations de réaction de position et de vitesse provenant des moyens de réaction de position de vitesse à la boucle de commande à réaction.

17. Un mécanisme d'obturateur tel que revendiqué dans la revendication 16, caractérisé en ce que les moyens de réaction de position comprennent un potentiomètre (72) agencé pour produire un signal de réaction de position indicatif de la position effective de l'obturateur (48); et les moyens de réaction de vitesse comprennent un différentiateur (112) couplé au potentiomètre (72) pour produire un signal de vitesse indicatif de la vitesse effective de l'obturateur (48).

18. Un mécanisme d'obturateur tel que revendiqué dans l'une quelconque des revendications 14 à 17, caractérisé en ce que les moyens de commande comprennent des moyens de traitement (82) pour fournir sélectivement des signaux d'instruction; et des moyens (88) formant registre couplés aux moyens de traitement (82) et à la boucle (91) de commande à réaction pour recevoir les signaux d'instruction des moyens de traitement afin de mettre la topologie de la boucle de commande à réaction sous une configuration appropriée pour la commande de vitesse du dispositif d'entraînement (54, 110) en réponse au signal d'instruction mentionné en premier lieu et pour mettre la topologie de la boucle de commande à réaction sous une forme appropriée pour la commande de position du dispositif d'entraînement en réponse au signal d'instruction mentionné en seconde lieu.

19. Un mécanisme d'obturateur tel que revendiqué dans la revendication 18, caractérisé en ce que les moyens (88) formant registre sont également couplés aux sources (82—86, et 72, 93, 112) de signaux de référence et de réaction pour commander sélectivement l'application des informations de référence et de réaction provenant de ces sources à la boucle (91) de commande à réaction.

**Patentansprüche**

1. Verschlußmechanismus (20) mit einem Gehäuse (32), das eine Verschlußöffnung (46) aufweist; einem Verschluß (48), der drehbar im Gehäuse zum Öffnen und Schließen der Verschlußöffnung angeordnet ist; und einer Antriebseinheit (54, 110), die mit dem Verschluß zum einsinnigen Drehen des Verschlusses mit einem variablen Geschwindigkeitsprofil während jeder Belichtungsperiode zwischen einer Anfangs-Ruhestellung und einer End-Ruhestellung gekuppelt ist, dadurch gekennzeichnet, daß die Öffnungsbewegung des Verschlusses zwischen der Anfangs-Ruhestellung und einer Zwischen-Ruhestellung (offen) bezüglich der Verschlußposition durch ein erstes variables Geschwindigkeitsprofil (78) gesteuert ist und daß die Schließbewegung des Verschlusses zwischen der Zwischen-Ruhestellung und der End-Ruhestellung bezüglich der Verschlußposition durch ein zweites variables Geschwindigkeitsprofil (78) gesteuert ist, welches dem ersten variablen Geschwindigkeitsprofil entspricht.

2. Verschlußmechanismus nach Anspruch 1, dadurch gekennzeichnet, daß die Antriebseinheit (54, 110) einen mit dem Verschluß (48) gekuppelten Antriebsmotor (54) zum Drehen des Verschlusses aufweist, wobei der Antriebsmotor im Gehäuse (32) koaxial mit dem Verschluß angeordnet ist.

3. Verschlußmechanismus nach Anspruch 1 oder 2, gekennzeichnet durch eine Positions-Rückmeldevorrichtung (72) zum Anzeigen der Position des Verschlusses (48).

4. Verschlußmechanismus nach Anspruch 3, dadurch gekennzeichnet, daß die Positions-Rückmeldevorrichtung (72) ein mit dem Verschluß (48) zu gemeinsamer Drehung gekuppeltes Steuerelement (70) aufweist.

5. Verschlußmechanismus nach Anspruch 3 oder 4, dadurch gekennzeichnet, daß die Antriebseinheit (54, 110) eine Geschwindigkeitsregelvorrichtung (112) aufweist, welche mit dem Antriebsmotor (54) gekuppelt ist und auf die Positions-Rückmeldevorrichtung (72) reagiert, um beide variablen Geschwindigkeitsprofile (78) des Verschlusses zu regeln.

6. Verschlußmechanismus nach einem der vorangehenden Ansprüche, dadurch gekennzeichnet, daß das Gehäuse (32) einen konisch ausgebildeten Spielraum (40) hat, der mit der Verschlußöffnung (46) kommuniziert; und daß der Verschluß als konisch gestalteter Verschluß (48) ausgebildet ist, der drehbar in dem konisch gestalteten Spielraum des Gehäuses untergebracht ist.

7. Verschlußmechanismus nach Anspruch 6, dadurch gekennzeichnet, daß die Verschlußöffnung (46) durch einen Teil des konisch gestalteten Spielraumes (40) ragt.

8. Verschlußmechanismus nach einem der vorangehenden Ansprüche, dadurch gekennzeichnet, daß der Verschluß (48) ein Paar diametral gegenüberliegende, einander entsprechende Verschlußabschnitte (50) aufweist, von denen jeder die Verschlußöffnung (46) vollständig schließen kann; und daß ein Paar diametral gegenüberliegende, einander entsprechende Öffnungen (52) relativ zu den Verschlußabschnitten orthogonal angeordnet und je zum vollständigen Öffnen der Verschlußöffnung betreibbar sind.

9. Verschlußmechanismus nach einem der vorangehenden Ansprüche, dadurch gekennzeichnet, daß eine Servo-Regelschaltung zum Regeln sowohl der Geschwindigkeit als auch der Position des Verschlusses (48) vorgesehen ist; daß die Servo-Regelschaltung eine Sollwert-Quelle (82, 84, 86) eine Rückmelde-Quelle (72, 93, 112) und eine mit der Antriebseinheit (54, 110) sowie der Sollwert- und Rückmelde-Quelle verbundene Rückführ-Regelschleife (91) aufweist; daß die Sollwert-Quelle (82, 84, 86) eine Sollwert-Quelle für Geschwindigkeits-und Positions-Sollwertinformation ist, die maßgeblich für die gewünschte Geschwindigkeit und Position des Verschlusses (48) ist; daß die Rückmelde-Quelle (72, 93, 112) eine Quelle für Geschwindigkeits- und Positions-Rückmeldeinformation ist, welche maßgeblich für die Ist-Geschwindigkeit und -Position des Verschlusses (48) ist; daß die Rückführ-Regelschleife eine für die Geschwindigkeitsregelung der Antriebseinheit (54, 110) ausbildbare Topologie aufweist, um die Geschwindigkeit des Verschlusses (48) abhängig von der Geschwindigkeits-Sollwertinformation und der Rückmelde- bzw. Istinformation der Rückmelde- und Sollwert-Quellen zu regeln, und daß die Topologie der Rückführ-Regelschleife zur Positionsregelung der Antriebseinheit (54, 110) unterschiedlich ausbildbar ist, um die Position des Verschlusses (48) gemäß der von den Sollwert-und Rückmelde-Quellen erhaltenen Positions-Sollwertinformation und -Rückmeldeinformation zu regeln; und daß eine Regelvorrichtung (82, 88) mit der Rückführ-Regelschleife gekuppelt ist, um die Topologie der Rückführ-Regelschleife auf ein Steuersignal hin für die Geschwindigkeitsregelung der Antriebseinheit (54, 110) auszubilden und die Topologie der Rückführ-Regelschleife für die Positionsregelung der Antriebseinheit (54, 110) abhängig von einem anderen Steuersignal für die Positionsregelung der Antriebseinheit (54, 110) unterschiedlich auszubilden.

10. Verschlußmechanismus nach Anspruch 9, dadurch gekennzeichnet, daß die Rückführ-Regelschleife (91) mit der Antriebseinheit (54, 110) und den Sollwert- und Rückmelde-Quellen (82 bis 86 und 72, 93, 112) gekuppelte Verstärkervorrichtung (92, 108) aufweist, um die Antriebseinheit mit einem auf die Differenz zwischen der Geschwindgkeitssollwert- und Rückmeldeinformation bezogenen Fehlersignal zu versorgen, wenn die Topologie der Rückführ-Regelschleife für Geschwindigkeitsregelung der Antriebseinheit ausgebildet ist, sowie mit einem Fehlersignal bezogen auf die Differenz zwischen Positions-Sollwert und Positions-Rückmeldeinformation, wenn die Topologie der Rückführ-Regelschleife für Positionsregelung der Antriebseinheit ausgebildet ist; daß ein Netzwerk (94 bis 106, 114, 116) in einer Schaltung mit der Verstärkervorrichtung verknüpft ist, um die Entdämpfungsfrequenz-Kontur der Rückführ-Regelschleife zu erhalten; und daß das Netzwerk eine Schaltvorrichtung (95 bis 98) zum Modifizieren der Entdämpfungsfrequenz-Kontur der Rückführ-Regelschleife abhängig von einem der erwähnten Steuersignale aufweist.

11. Verschlußmechanismus nach Anspruch 10, dadurch gekennzeichnet, daß die Verstärkervorrichtung einen ersten Verstärker (92) mit ersten und zweiten, je mit der Sollwert-Quelle und der Rückmelde-Quelle verbundenen Eingängen und einen zweiten Verstärker (108) mit einem in Reihe mit einem Ausgang des ersten Verstärkers geschalteten Eingang und einem mit der Antriebseinheit verbundenen Ausgang aufweist; daß das Netzwerk ein erstes Netzwerk (100, 102, 114) zum Bilden eines Rückmelde-Pfades vom ersten oder zweiten Eingang zum Ausgang des ersten Verstärkers und ein zweites Netzwerk (104, 116) zum Verbinden des Ausgangs des ersten Verstärkers mit dem vorerwähnten Eingang des zweiten Verstärkers umfaßt; und daß die Schaltvorrichtung erste und zweite Schalter (95, 96, 98) in den ersten und zweiten Netzwerken aufweist.

12. Verschlußmechanismus nach Anspruch 11, dadurch gekennzeichnet, daß das erste Netzwerk ein erstes Netzwerkparr (102, 114) aufweist, welches in Parallelschaltung vom ersten oder zweiten Eingang zum Ausgang des ersten Verstärkers (92) führt; daß das zweite Netzwerk ein zweites Netzwerkpaar (104, 116) aufweist, welches in Parallelschaltung vom Ausgang des ersten Verstärkers (92) zum erwähnten Eingang des zweiten Verstärkers (108) führt; daß die erste Schaltvorrichtung einen Schalter (95) umfaßt, der in Reihe mit einem Netzwerk (114) des ersten Netzwerkpaares vom ersten oder zweiten Eingang zum Ausgang des ersten Verstärkers (92) angeordnet ist, um abhängig von einem der Steuersignale geöffnet oder geschlossen zu werden; und daß die zweite Schaltvorrichtung einen Schalter (98) aufweist, der in Reihe mit einem Netzwerk (116) des zweiten Netzwerkpaares vom Ausgang des ersten Verstärkers (92) zum vorerwähnten Eingang des zweiten Verstärkers (108) geschaltet ist, um abhängig von einem der Steuersignale geöffnet oder geschlossen zu werden.

13. Verschlußmechanismus nach Anspruch 12, dadurch gekennzeichnet, daß das erste Netzwerk ferner ein zusätzliches Netzwerk (100) umfaßt, welches in Reihe mit dem anderen Netzwerk (102) des ersten Netzwerkpaares vom ersten oder zweiten Eingang zum Ausgang des ersten Verstärkers (92) geschaltet ist; und daß die erste Schaltvorrichtung ferner einen zusätzlichen Schalter (96) umfaßt, der parallel mit dem zusätzlichen Netzwerk (100) geschaltet ist, um abhängig von einem der Steuersignale geöffnet oder geschlossen zu werden.

14. Verschlußmechanismus nach einem der Ansprüche 9 bis 13, dadurch gekennzeichnet, daß die Sollwert-Quelle (82, 84, 86) umfaßt: eine Verarbeitungsvorrichtung (82) zum Speichern und wahlweisen Ausgeben der Geschwindigkeits- und Positions-Sollwertinformation in einer ersten, mit der Verarbeitungsvorrichtung kompatiblen Form; eine mit der Verarbeitungsvorrichtung (82) und der Rückführ-Regelschleife (91) verknüpften Wandelvorrichtung (84), um die Geschwindigkeits- und Positions-Sollwertinformation aus der Verarbeitungsvorrichtung in eine zweite Form umzuwandeln, welche mit der Rückführ-Regelschleife kompatibel ist; und eine Vorrichtung zum Verknüpfen der Wandelvorrichtung (84) mit der Rückführ-Regelschleife (91), um die gewandelte Geschwindigkeits- und Positions-Sollwertinformation aus der Wandelvorrichtung zur Rückführ-Regelschleife zu speisen.

15. Verschlußmechanismus nach Anspruch 14, dadurch gekennzeichnet, daß die Verarbeitungsvorrichtung einen digitalen Rechner (82) aufweist; und daß die Wandelvorrichtung einen Digital-Analog-Wandler (84) zum Wandeln der digitalen Geschwindigkeits- und Positions-Sollwertinformation aus dem digitalen Rechner in analoge Geschwindigkeits- und Positions-Sollertinformation für die Rückführ-Regelschleife aufweist.

16. Verschlußmechanismus nach einem der Ansprüche 9 bis 15, dadurch gekennzeichnet, daß die Rückführ-Quelle einen Positionsgeber (72) zum Erfassen der Position des Verschlusses (48); einen Geschwindigkeitsgeber (112) zum Erfassen der Geschwindigkeit des Verschlusses (48) und Mittel (93) zum Verbinden des Positionsgebers und des Geschwindigkeitsgebers (72, 112) mit der Rückführ-Regelschleife (91) umfaßt, um die Positions- und Geschwindigkeits-Rückführinformation von den Positions- und Geschwindigkeitsgebern zu der Rückführ-Regelschleife zu speisen.

17. Verschlußmechanismus nach Anspruch 16, dadurch gekennzeichnet, daß der Positionsgeber ein Potentiometer (72) zum Erzeugen eines Positions-Rückmeldesignals aufweist, welches die Ist-Position des Verschlusses (48) anzeigt; und daß der Geschwindigkeitsgeber einen mit dem Potentiometer (72) gekuppelten Differenzierer (112) aufweist, um ein Geschwindigkeits-Rückmeldesignal zu erzeugen, welches repräsentativ für Ist-Geschwindigkeit des Verschlusses (48) ist.

18. Verschlußmechanismus nach einem der Ansprüche 14 bis 17, dadurch gekennzeichnet, daß die Regelvorrichtung eine Verarbeitunsvorrichtung (82) zum wahlweisen Bereitstellen der Steuersignale sowie eine mit der Verarbeitungsvorrichtung (82) und der Rückführ-Regelschleife verbundene Registervorrichtung (88) zum Empfangen der Steuersignale aus der Verarbeitungsvorrichtung umfaßt, um die Topologie der Rückführ-Regelschleife auf Empfang des zuerst genannten Steuersignals für eine Geschwindigkeitsregelung der Antriebseinheit (54, 110) auszubilden und die Topologie der Rückführ-Regelschleife auf Empfang des zweitgenannten Steuersignals für eine Positionsregelung der Antriebseinheit unterschiedlich auszubilden.

19. Verschlußmechanismus nach Anspruch 18, dadurch gekennzeichnet, daß die Registervorrichtung (88) auch mit den Sollwert-und Rückmelde-Quellen (82 bis 86 und 72, 93, 112) verbunden ist, um wahlweise die Aufschaltung von Sollwert- und Rückmeldeinformation aus diesen Quellen auf die Rückführ-Regelschleife (91) zu kontrollieren.

Fig 1

Fig 2B

Fig 2A

0 026 884

Fig 3A

Fig 3B

ONE COMPLETE CYCLE OF SHUTTER OPERATION

+ VELOCITY_MAX

78    78

90    90

90    90

90

90

90

90

90

80    80

90

OPENING    OPEN    CLOSING    CLOSED

CLOSED    OPENING    OPEN    CLOSING    CLOSED

− VELOCITY_MIN

TIME

Fig 4

0 026 884

Fig 5

Fig 6